# EUROPEAN PATENT SPECIFICATION

(11) **EP 1 772 754 B1**
(45) Date of publication and mention of the grant of the patent: **21.07.2010**
(21) Application number: 06121430.0
(22) Date of filing: 28.09.2006
(51) Int. Cl.: G02B 1/04, G02B 6/12, C08F 290/12

(54) **Radiation-sensitive resin composition for optical waveguides, optical waveguide, and method for manufacturing optical waveguide**
Strahlenhärtende Zusammensetzung für optische Lichtleiter, optische Lichtleiter und deren Herstellungsmethode
Composition de résine sensible aux rayonnements pour guides d'onde optique, guides d'ondes optique et procédé de fabrication

(30) Priority: 29.09.2005 JP 2005285699
(43) Date of publication of application: 11.04.2007
(73) Proprietor: JSR Corporation, Tokyo 104-8410 (JP)
(72) Inventor: Maeda, Yukio, Tokyo Tokyo 104-8410 (JP); Eriyama, Yuuichi, Tokyo Tokyo 104-8410 (JP)
(74) Representative: TBK-Patent

(56) References cited:
- JP-A- 7 077 614
- JP-A- 2003 195 079
- US-A- 5 903 399

## Description

### BACKGROUND OF THE INVENTION

### 1. Field of the Invention

The present invention relates to a radiation-sensitive resin composition for optical waveguides, and more particularly relates to a radiation-sensitive resin composition for forming optical waveguides having high dimensional accuracy, good transmission characteristics, and excellent bending resistance.

### 2. Description of the Related Art

As it is now coming a multimedia era and there has been increased demand for a high-speed and high-capacity data processing in optical communication systems and computers, optical waveguides have come to receive attention as optical transmission medium. A silica optical waveguide, which is a typical example of conventional optical waveguides, is generally manufactured by the following steps (1) to (3).
(1) A lower clad layer composed of a glass film is formed on a silicon support using flame hydrolysis deposition (FHD), CVD method, or the like.
(2) An inorganic thin film having a higher refractive index than the refractive index of the lower clad layer is formed on the lower clad layer and the thin film is patterned using reactive ion etching, thus forming a core portion.
(3) Moreover, an upper clad layer is formed using flame hydrolysis deposition.

However, such method for manufacturing a silica optical waveguide has problems that a special manufacturing apparatus is required and that it takes a long time to manufacture the optical waveguide.

To solve the problems described above, there has been proposed a method in which prescribed parts of a silicone composition including a photo-polymerizable component are irradiated with a prescribed amount of light to be cured, and then, the unexposed parts are developed to form a core portion and the like, thus manufacturing an optical waveguide (see Japanese Laid-Open Patent Publication 2000-180693).

Compared with the conventional method for manufacturing a silica optical waveguide, this method has an advantage of manufacturing an optical waveguide in a shorter time and at lower cost. However, the method has a restriction such that a special silicone oligomer is needed.

On the other hand, there has been proposed a radiation-curable composition for forming optical waveguides comprising (A) a vinyl polymer having carboxyl groups, polymerizable groups, and other organic groups, (B) a compound having at least two polymerizable reactive groups in its molecule, and (C) a radiation polymerization initiator(see Japanese Laid-Open Patent Publication 2003-195079). By using this composition, an optical waveguide having high dimensional accuracy and excellent transmission characteristics can be formed.

### SUMMARY OF THE INVENTION

The inventors have found out that the optical waveguide formed by using the radiation-curable composition comprising the components (A) to (C) described above has high dimensional accuracy and excellent transmission characteristics, but the optical waveguide has a disadvantage such that the optical waveguide, which has a form of film which is a cured product, cracks or ruptures when bended.

It is thus an object of the present invention to provide a radiation-sensitive resin composition by which optical waveguides having high dimensional accuracy, good transmission characteristics (i.e. waveguide loss), and excellent bending resistance can be formed.

As a result of diligent study aimed at solving the above problems, the inventors perfected the present invention upon discovering that by curing a liquid composition which includes several components having specific chemical structures with radiation, an optical waveguide having high dimensional accuracy, good transmission characteristics (i.e. waveguide loss), and excellent bending resistance can be formed.

That is, the present invention provides the following [1] to [6].
[1] A radiation-sensitive resin composition for optical waveguides, comprising:
   (A) a polymer having a repeating unit represented by the following general formula (1) 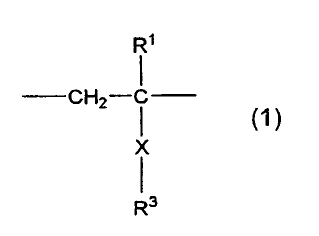 (in the formula, R¹ is a hydrogen atom or a methyl group, R³ is a (meth)acryloyl group, X is a bivalent organic group);
   (B) an urethane (meth)acrylate compound which is a reaction product of a polyester polyol compound, a polyisocyanate compound, and a (meth)acrylate having a hydroxyl group;
   (C) a compound having at least one ethylenically unsaturated group and having a boiling point of 130 degree C or higher under 0.1 MPa other than components (A) and (B); and
   (D) a photo-radical polymerization initiator.
[2] The radiation-sensitive resin composition according to [1], wherein the general formula (1) represents a structure represented by the following general formula (3) 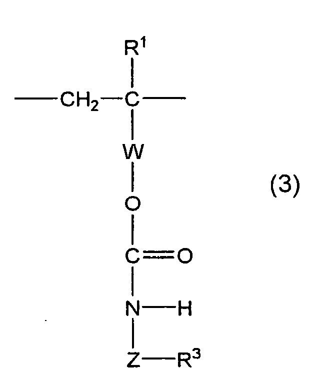 (in the formula, R¹ is a hydrogen atom or a methyl group, R³ is a (meth)acryloyl group, W and Z are each independently a single bond or a bivalent organic group).
[3] The radiation-sensitive resin composition according to [1] or [2], wherein component (B) has a number average molecular weight in terms of polystyrene, as measured by gel permeation chromatography, of 1,000 to 100,000.
[4] An optical waveguide comprising a lower clad layer, a core portion, and an upper clad layer, wherein at least each of the lower clad layer and the upper clad layer is a cured product of the radiation-sensitive resin composition for optical waveguides according to any one of [1] to [3].
[5] The optical waveguide according to [4], wherein each of the lower clad layer, the core portion, and the upper clad layer is a cured product of the radiation-sensitive resin composition according to any one of [1] to [3], and the core portion has a refractive index at least 0.1 % higher than respective refractive indexes of the lower clad layer and the upper clad layer.
[6] A method for manufacturing an optical waveguide comprising a lower clad layer, a core portion, and an upper clad layer, wherein the method comprises a step for forming the lower clad layer, a step for forming the core portion, and a step for forming the upper clad layer, and wherein at least each of the step for forming the lower clad layer and the step for forming the upper clad layer includes a step in which the radiation-sensitive resin composition according to any one of [1] to [3] is irradiated with radiation to be cured.

By using the radiation-sensitive resin composition for optical waveguides of the present invention, it is possible to manufacture optical waveguides with high dimensional accuracy, good transmission characteristics (i.e. waveguide loss), and excellent bending resistance.

### BRIEF DESCRIPTION OF THE DRAWINGS

FIG. 1 is a sectional view schematically illustrating an example of an optical waveguide of the present invention; and
FIG. 2 is a flow diagram illustrating an example of a method for manufacturing an optical waveguide of the present invention.

### DESCRIPTION OF THE PREFERRED EMBODIMENTS

Components (A) to (D) and other optional components, which constitute a radiation-sensitive resin composition for optical waveguides of the present invention, will now be described in detail.

### [Component (A)]

Component (A) used in the present invention is a polymer (e.g. a random copolymer) having a repeating unit represented by the following general formula (1). Component (A) usually has a repeating unit represented by the following general formula (2) in addition to the repeating unit represented by the following general formula (1). 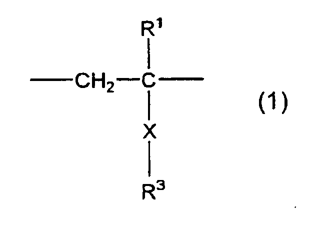 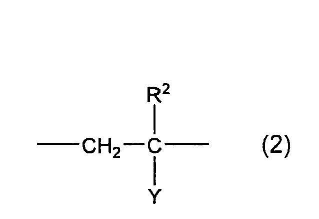 (In the formulae, R¹ and R² are each independently a hydrogen atom or a methyl group; R³ is a (meth)acryloyl group; X is a bivalent organic group; Y is a non-polymerizable organic group.)

A preferred example of the repeating unit represented by the general formula (1) is a repeating unit represented by the following general formula (3). 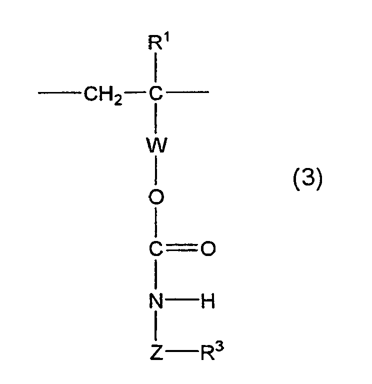 (In the formula, R¹ is a hydrogen atom or a methyl group; R³ is a (meth)acryloyl group; W and Z are each independently a single bond or a bivalent organic group.)

Here, examples of W (i.e. bivalent organic group) in the general formula (3) include a structure represented by the following general formula (4), a phenylene group, and the like. 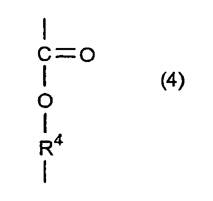 (In the formula, R⁴ is a methylene or an alkylene having 2 to 8 carbon atoms.)

Examples of Z (i.e. bivalent organic group) in the general formula (3) include -(CH₂)ₙ-O- (in the formula, n is an integer of 1 to 8), and the like.

Examples of Y in the general formula (2) include a structure represented by the following general formula (5), a phenyl group, a cyclic amido group, a pyridyl group, and the like. 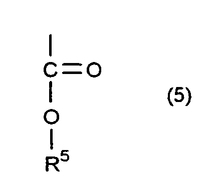 (In the formula, R⁵ is a group having a linear, branched, or cyclic carbon chain having 1 to 20 carbon atoms.)

Component (A) has a weight average molecular weight in terms of polystyrene of preferably from 5,000 to 100,000, more preferably from 8,000 to 70,000, most preferably from 10,000 to 50, 000. When the weight average molecular weight is less than 5, 000, it is impossible to obtain a film having a desirable thickness due to decreased viscosity of the composition. When the weight average molecular weight exceeds 100, 000, it is difficult to apply the composition due to increased viscosity of the composition.

Examples of a method for manufacturing component (A) in which (a) the radical polymerizable compound having a hydroxyl group and component (b) (i.e. the radical polymerizable compound corresponding to the general formula (2)) are radical polymerized to obtain a copolymer in a solvent, and then, (c) an isocyanate having a (meth) acryloyloxy group is added to the hydroxyl groups in side chains of the obtained copolymer.

Compounds (a) to (c) used in this method will now be described.

Compound (a) (i.e. a radical polymerizable compound having a hydroxyl group) is used so that the hydroxyl group therein can be reacted with the isocyanate group (i.e. -N=C=O) in compound (c), resulting in that an urethane linkage (i.e. -NH-COO-) and a constituent unit including a side chain having a (meth)acryloyloxy group of compound (c) are introduced into component (A).

Examples of compound (a) include 2-hydroxyethyl (meth)acrylate, 2-hydroxypropyl (meth)acrylate, 4-hydroxybutyl (meth)acrylate, hydroxymethyl (meth)acrylate, 4-hydroxycyclohexyl (meth)acrylate, and the like.

Such compound (a) can be used singly or in combination of two or more.

Compound (a) is included in component (A) in an amount of preferably from 3 to 80 mass percent, more preferably from 7 to 60 mass percent, most preferably from 10 to 40 mass percent of component (A).

When the amount is less than 3 mass percent, curing tends to decrease. When the amount exceeds 80 mass percent, it is sometimes difficult to adjust the refractive index.

Compound (b) (i.e. a compound corresponding to the structure of the general formula (2)) is used mainly for appropriately controlling the refractive index and mechanical properties of component (A).

Examples of compound (b) include alkyl (meth)acrylate esters such as methyl (meth)acrylate, ethyl (meth)acrylate, isopropyl (meth)acrylate, n-butyl (meth)acrylate, sec-butyl (meth)acrylate, t-butyl (meth)acrylate, and the like; esters between (meth)acrylic acid and cyclic hydrocarbon compound such as dicyclopentanyl (meth)acrylate, cyclohexyl (meth)acrylate, and the like; aryl (meth)acrylate esters such as phenyl (meth)acrylate, benzyl (meth)acrylate, o-phenylphenol glycidyl ether (meth)acrylate, p-cumylphenoxy ethylene glycol acrylate, and the like; halogenated (meth)acrylate esters such as tribromophenolethoxy (meth)acrylate, 2,2,2-trifluoromethyl (meth)acrylate, 2,2,3,3-tetrafluoropropyl (meth)acrylate, 1H,1H,5H-octafluoropentyl (meth)acrylate, perfluorooctylethyl (meth)acrylate, and the like; aromatic vinyls such as styrene, α-methylstyrene, m-methylstyrene, p-methylstyrene, vinyltoluene, p-methoxystyrene, and the like; conjugated diolefins such as 1,3-butadiene, isoprene, 1,4-dimethylbutadiene, and the like; nitrile group-containing polymerizable compounds such as acrylonitrile, methacrylonitrile, and the like; amido bond-containing polymerizable compounds such as acrylamide, methacrylamide, and the like; aliphatic vinyls such as vinyl acetate, and the like.

Of these, dicyclopentanyl (meth)acrylate, methyl (meth)acrylate, n-butyl (meth)acrylate, styrene, α-methylstyrene are preferably used.

Such compound (b) can be used singly or in combination of two or more..

Compound (b) is included in component (A) in an amount of preferably from 15 to 92 mass percent, more preferably from 25 to 84 mass percent, most preferably from 35 to 78 mass percent of component (A).

When the amount is less than 15 mass percent, it is sometimes difficult to adjust the refractive index. When the amount exceeds 92 mass percent, curing tends to decrease.

Examples of compound (c) (i.e. an isocyanate having a (meth) acryloyloxy group) include 2-methacryloxyethyl isocyanate, N-methacryloyl isocyanate, methacryloxymethyl isocyanate, 2-acryloxyethyl isocyanate, N-acryloyl isocyanate, acryloxymethyl isocyanate, and the like.

Compound (c) is included in component (A) in an amount of preferably from 5 to 80 mass percent, more preferably from 9 to 60 mass percent, most preferably from 12 to 45 mass percent of component (A).

When the amount is less than 5 mass percent, curing tends to decrease. When the amount exceeds 80 mass percent, it is sometimes difficult to adjust the refractive index.

Component (A) can include a structural unit not described in either general formula (1) or (2). Examples of compounds used for introducing such structural units (hereinafter referred to as compound (d)) include dicarboxylic acid diesters such as diethyl maleate, diethyl fumarate, diethyl itaconate, and the like; chlorine-containing polymerizable compounds such as vinyl chloride, vinylidene chloride, and the like. Compound (d) is included in component (A) in an amount of preferably from 0 to 20 mass percent, more preferably from 0 to 10 mass percent of component (A).

It is possible to add various additives such as a thermal polymerization inhibitor, a storage stabilizer, a curing catalyst, and the like at the time of the addition reaction of compound (c) in the process of manufacturing component (A).

A thermal polymerization inhibitor is added in order to inhibit a polymerization reaction caused by heat. Examples of thermal polymerization inhibitors include pyrogallol, benzoquinone, hydroquinone, Methylene Blue, tert-butylcatechol, monobenzyl ether, methoxyphenol, amylquinone, amyloxyhydroquinone, n-butylphenol, phenol, hydroquinone monopropyl ether, and the like.

Examples of storage stabilizers include 2,6-di-t-butyl-p-cresol, benzoquinone, p-toluquinone, p-xyloquinone, phenyl-α-naphthylamine, and the like.

Examples of curing catalysts include dibutyltin dilaurate, dioctyltin dilaurate, dibutyltin dioleate, dibutyltin diacetate, tetramethoxytitanium, tetraethoxytitanium, and the like.

The total amount of the additives is usually not more than 10 mass parts, preferably not more than 5 mass parts, based on 100 mass parts of the total amount of compounds (a), (b) and (c).

Examples of the solvent used for the radical polymerization of compound (a) and the optional compounds (b) and (d) in the manufacture of component (A) include alcohols such as methanol, ethanol, ethylene glycol, diethylene glycol, propylene glycol, and the like; cyclic ethers such as tetrahydrofuran, dioxane, and the like; polyhydric alcohol alkyl ethers such as ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether, propylene glycol monoethyl ether, and the like; polyhydric alcohol alkyl ether acetates such as ethylene glycol ethyl ether acetate, diethylene glycol ethyl ether acetate, propylene glycol ethyl ether acetate, propylene glycol monomethyl ether acetate, and the like; aromatic hydrocarbons such as toluene, xylene, and the like; ketones such as acetone, methyl ethyl ketone, methyl isobutyl ketone, cyclohexanone, 4-hydroxy-4-methyl-2-pentanone, diacetone alcohol, and the like; esters such as ethyl acetate, butyl acetate, ethyl lactate, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, and the like.

Of these, cyclic ethers, polyhydric alcohol alkyl ethers, polyhydric alcohol alkyl ether acetates, ketones, esters are preferred.

On the other hand, for the addition reaction of compound (c) in the manufacture of component (A), it is not preferable to use a solvent having a hydroxyl group in its molecule, because compound (c) reacts with the solvent. Therefore, the solvent used for the addition reaction of compound (c) preferably does not have a hydroxyl group. Examples of the solvent not having a hydroxyl group include a solvent not having a hydroxyl group selected from the solvents used for the radical polymerization described above.

As a catalyst for the radical polymerization used in the manufacture of component (A), any ordinary radical polymerization initiator can be employed. Examples of the radical polymerization initiator include azo compounds such as 2,2'-azobisisobutyronitrile, 2,2'-azobis(2,4-dimethylvaleronitrile), 2,2'-azobis(4-methoxy-2,4-dimethylvaleronitrile), and the like; organic peroxides such as benzoyl peroxide, lauroyl peroxide, t-butyl peroxypivalate, 1,1'-bis(t-butylperoxy)cyclohexane, and the like; and hydrogen peroxide. When the peroxide is used as the radical polymerization initiator, the peroxide may be used with a reductant to be a redox-type initiator.

### [Component (B)]

Component (B) is an urethane (meth)acrylate compound obtained by reacting a polyester polyol compound, a polyisocyanate compound, and a (meth)acrylate having a hydroxyl group.

Examples of the method for manufacturing component (B) include Methods 1 to 4 described below.
Method 1 : a method of reacting a polyol compound, a polyisocyanate compound, and a (meth)acrylate having a hydroxyl group all together.
Method 2: a method of reacting a polyol compound and a polyisocyanate compound to produce a product, and then, reacting the product and a (meth)acrylate having a hydroxyl group.
Method 3: a method of reacting a polyisocyanate compound and a (meth) acrylate having a hydroxyl group to produce a product, and then, reacting the product and a polyol compound.
Method 4: a method of reacting a polyisocyanate compound and a (meth) acrylate having a hydroxyl group to produce a product, and then, reacting the product and a polyol compound to produce another product, and finally reacting the another product and a (meth)acrylate having a hydroxyl group.

Among the above Methods 1 to 4, Methods 2 to 4 are preferred in view of controlling the molecular weight distribution.

### (1) Polyester and polyol compound

The polyol compound, which is one of the materials of component (B), is a compound having at least two hydroxyl groups in its molecule. Examples of such compounds include aromatic polyether polyols, aliphatic polyether polyols, cycloaliphatic polyether polyols, polyester polyols, polycarbonate polyols, polycaprolactone polyols, and the like.

It is preferable to use a polyether polyol compound having an alkyleneoxy structure among the compound described above so that a support and an optical waveguide can be bonded more strongly.

Examples of aromatic polyether polyols include diols such as ethylene oxide adduct of bisphenol A, propylene oxide adduct of bisphenol A, butylene oxide adduct of bisphenol A, ethylene oxide adduct of bisphenol F, propylene oxide adduct of bisphenol F, alkylene oxide adduct of hydroquinone, alkylene oxide adduct of naphthoquinone, and the like. The aromatic polyether polyols are available as commercial compounds under the trade names of UNIOL, DA700, DA1000 (manufactured by Nippon Oil and Fats Co, Ltd.); and the like.

Examples of aliphatic polyether polyols include compounds obtained by open-ringing (co)polymerizing at least one compound selected from the group consisting of ethylene oxide, propylene oxide, butylene oxide, tetrahydrofuran, 2-methyltetrahydrofuran 3-methyltetrahydrofuran, substituted tetrahydrofuran, oxetane, substituted oxetane, tetrahydropyran, oxepane, and the like. Specific examples of the aliphatic polyether polyol include polyethylene glycol, 1, 2-polypropylene glycol, 1, 3-polypropylene glycol, polytetramethylene glycol, 1,2-polybutylene glycol, polyisobutylene glycol; polyols such as copolymer of propylene oxide and tetrahydrofuran, copolymer of ethylene oxide and tetrahydrofuran, copolymer of ethylene oxide and propylene oxide, copolymer of tetrahydrofuran and 3-methyltetrahydrofuran, copolymer of ethylene oxide and 1, 2-butylene oxide; and the like.

Examples of cycloaliphatic polyether polyols include diols such as ethylene oxide adduct of hydrogenated bisphenol A, propylene oxide adduct of hydrogenated bisphenol A, butylene oxide adduct of hydrogenated bisphenol A, ethylene oxide adduct of hydrogenated bisphenol F, propylene oxide adduct of hydrogenated bisphenol F, butylene oxide adduct of hydrogenated bisphenol F; dimethylol adduct of dicyclopentadiene, tricyclodecan dimethanol, and the like.

The aliphatic polyether polyols and the cycloaliphatic polyether polyols are available as commercial compounds under the trade names of UNISAFE DC1100, UNISAFE DC1800, UNISAFE DCB1100, UNISAFE DCB1800 (manufactured by Nippon Oil and Fats Co, Ltd); PPTG4000, PPTG2000, PPTG1000, PTG2000, PTG3000, PTG650, PTGL2000, PTGL1000 (manufactured by Hodogaya Chemical Co., LTD.); EXENOL4020, EXENOL3020, EXENOL2020, EXENOL1020 (manufactured by ASAHI GLASS CO., LTD); PBG3000, PBG2000, PBG1000, Z3001 (manufactured by DAI-ICHI KOGYO SEIYAKU CO., LTD.); ACCLAIM 2200, 3201, 4200, 6300, 8200 (manufactured by Sumika Bayer Urethane Co., Ltd.); NPML-2002, 3002, 4002, 8002 (manufactured by ASAHI GLASS CO., LTD); and the like.

Examples of polyester polyols include polyester polyols which are reaction products obtained by reacting polyhydric alcohol such as ethylene glycol, polyethylene glycol, propylene glycol, polypropylene glycol, tetramethylene glycol, polytetramethylene glycol, 1,6-hexanediol, neopentyl glycol, 1,4-cyclohexanedimethanol, 3-methyl-1,5-pentanediol, 1,9-nonanediol, 2-methyl-1,8-octanediol, and the like, and polyprotic acid such as phthalic acid, isophthalic acid, terephthlic acid, maleic acid, furmic acid, adipic acid, sebacic acid, and the like. The polyester polyols are available as commercial compounds under the trade names of P-2010, PMIPA, PKA-A, PKA-A2, PNA-2000 (manufactured by KURARAY CO., LTD.); and the like.

Examples of polycarbonate polyols include 1,6-hexane polycarbonate, and the like. The polycarbonate polyols are available as commercial compounds under the trade names of DN-980, 981, 982,983 (manufactured by NIPPON POLYURETHANE INDUSTRY CO., LTD.); PLACCEL-CD205, CD-983, CD220 (manufactured by DAICEL CHEMICAL INDUSTRIES, LTD.); PC-800 (manufactured by PPG Industries); and the like.

Examples of polycaprolacton polyols include polycaprolacton diols which are reaction products between ε-caprolacton and diol such as ethylene glycol, polyethylene glycol, propylene glycol, polypropylene glycol, tetramethylene glycol, polytetramethylene glycol, 1,2-polybutylene glycol, 1,6-hexanediol, neopentyl glycol, 1,4-cyclohexanedimethanol, 1,4-butanediol, and the like. The polycaprolacton polyols are available as commercial compounds under the trade names of PLACCCEL205, 205AL, 212, 212AL, 220, 220AL (manufactured by DAICEL CHEMICAL INDUSTRIES, LTD.); and the like.

Examples of other polyol compounds availably used in the present invention include ethylene glycol, propylene glycol, 1,4-butanediol, 1,5-pentanediol, 1,6-hexanediol, neopentyl glycol, 1,4-cyclohexanedimethanol, polyβ-methyl-δ-valerolactone, hydroxyl-terminated polybutadiene, hydroxyl-terminated hydrogenated polybutadiene, ricinus modified polyol, diol-terminated polydimethylsiloxane, polydimethylsiloxane Carbitol modified polyol, and the like.

Preferred examples of the polyol compounds described above include polypropylene glycol; and diols such as an ethylene oxide/propylene oxide copolymer, ethylene oxide/1,2-butylene oxide copolymer, propylene oxide/tetrahydrofuran copolymer. The ethylene oxide/1,2-butylene oxide copolymer diol is more preferred.

The polyol compound has a number average molecular weight of preferably from 400 to 10,000, more preferably from 1,000 to 8,000, and most preferably from 1,500 to 5,000. When the number average molecular weight is less than 400, Young's modulus of a cured material increases at room or low temperature, resulting in insufficient bending resistance. On the other hand, when the number average molecular weight exceeds 10,000, it is sometimes difficult to apply the composition onto a support because of increased viscosity of the composition.

### (2) Polyisocyanate compound

The polyisocyanate compound which is one of the materials of component (B) is a compound having at least two isocyanate groups in its molecule. Examples of such compounds include diisocyanate compounds such as 2,4-tolylene diisocyanate, 2,6-tolylene diisocyante,1,3-xylylene diisocyanate, 1,4-xylylene diisocyanate, 1,5-naphthalene diisocyanate, m-phenylene diisocyanate, p-phenylene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate, 1,6-hexane di diisocyanate, isophorone diisocyanate, methylene bis(4-cyclohexylisocyanate), 2,2,4-trimethylhexamethylene diisocyanate, 1,4-hexamethylene diisocyanate, bis(2-isocyanate ethyl)fumarate, 6-isopropyl-1,3-phenyl diisocyanate, 4-diphenylpropane diisocyanate, lysine diisocyanate, hydrogenated diphenylmethane diisocyanate, hydrogenated xylylene diisocyanate, tetramethylxylylene diisocyanate, and the like. Of these, hydrogenated xylylene diisocyanate, isophorone diisocyanate, 2,2,4-trimethylhexamethylene diisocyanate are preferred. Such polyisocyanate compound can be used singly or in combination of two or more.

### (3) (Meth)acrylate having a hydroxyl group

The (meth) acrylate having a hydroxyl group which is one of the materials of component (B) is a compound having a hydroxyl group and a (meth) acryloyl group in its molecule. Examples of such compounds include 2-hydroxyethyl (meth)acrylate,2-hydroxypropyl (meth)acrylate, 2-hydroxybutyl (meth)acrylate, 2-hydroxy-3-phenyloxypropyl (meth)acrylate, 4-hydroxybutyl (meth)acrylate, 2-hydroxyalkyl (meth)acryloyl phosphate, 4-hydroxycyclohexyl (meth)acrylate, 6-hydroxyhexyl (meth)acrylate, neopentyl glycol mono(meth)acrylate, trimethylolpropane di(meth)acrylate, trimethylolethane di(meth)acrylate, pentaerythritol tri(meth)acrylate, dipentaerythritol penta(meth)acrylate, and the like. Moreover, examples of such compound includes an addition reaction compound between a glycidyl group-containing compound such as alkyl glycidyl ether, allyl glycidyl ether, and glycidyl (meth) acrylate, and (meth)acrylic acid.

Of these, 2-hydroxyethyl (meth)acrylate, 2-hydroxypropyl (meth)acrylate are preferred.

The mole ratios of the materials of Component (B) is such that the mole ratio of the polyester polyol compound to the (meth) acrylate having a hydroxyl group is 0.5 to 2, and the mole ratio of the polyisocyanate compound to the (meth) acrylate having a hydroxyl group is 1 to 2.5.

Component (B) has a number average molecular weight in terms of polystyrene, as measured by gel permeation chromatography, of preferably from 1,000 to 100,000, more preferably from 3,000 to 60,000, most preferably from 5,000 to 30,000. When the number average molecular weight is less than 1,000, the film of the cured material has difficulty in providing sufficient resistance to bending. When the number average molecular weight exceeds 100, 000, it is sometimes difficult to apply the composition because of increased viscosity of the composition.

In the composition of the present invention, the amount of component (B) is preferably 10 to 100 mass parts, more preferably 20 to 80 mass parts, most preferably 35 to 70 mass parts, per 100 mass parts of component (A). When the amount is less than 10 mass parts, it is sometimes difficult to provide sufficient bending resistance to the film of the cured material. When the amount exceeds 100 mass parts, component (B) has poor compatibility with component (A), so that the surface of the cured material sometimes becomes rough and sufficient transparency sometimes can not be obtained.

### [Component (C)]

Component (C) is a compound having at least one ethylenically unsaturated group and having a boiling point of 130 degree C or higher under 0.1 MPa other than components (A) and (B).

Here, examples of the ethylenically unsaturated group include a (meth)acryloyl group, a vinyl group, and the like.

Component (C) has a molecular weight of preferably less than 2,000, more preferably less than 1,000.

Preferred examples of component (C) having two or more ethylenically unsaturated groups include a compound having two or more (meth)acryloyl groups and/or vinyl groups and having a molecular weight of less than 1,000.

In this case, the ethylenically unsaturated group may consist only of acryloyl group, methacryloyl group, or vinyl group, or may be a combination of acryloyl group and methacryloyl group, a combination of acryloyl group and vinyl group, a combination of methacryloyl group and vinyl group, or a combination of acryloyl group, methacryloyl group, and vinyl group.

Examples of (meth) acrylate having two (meth) acryloyl groups include ethylene glycol di(meth)acrylate, tetraethylene glycol di(meth)acrylate, polyethylene glycol di(meth)acrylate,1,4-butanediol di(meth)acrylate, 1,6-hexanediol di(meth)acrylate, neopentyl glycol di(meth)acrylate, tris(2-hydroxyethyl) isocyanurate di(meth)acrylate, bis(hydroxymethyl)tricyclodecane di (meth) acrylate, di (meth) acrylate of a diol which is an ethylene oxide adduct or a propylene oxide adduct of bisphenol A, di(meth)acrylate of a diol which is an ethylene oxide adduct or a propylene oxide adduct of hydrogenated bisphenol A, epoxy (meth)acrylate which is a (meth)acrylate adduct of a diglycidyl ether of bisphenol A, diacrylate of polyoxyalkylenated bisphenol A, 9,9-bis[4-(2-acryloyloxyethoxy)phenyl]fluorene, and the like.

Examples of (meth)acrylate having three or more (meth)acryloyl groups include ester compounds of polyhydric alcohol having three or more hydroxyl groups with three or more moles of (meth)acrylic acid, such as trimethylolpropane tri(meth)acrylate, pentaerythritol tri(meth)acrylate, trimethylolpropanetrioxyethyl (meth)acrylate, tris(2-hydroxyethyl)isocyanurate tri(meth)acrylate, dipentaerythritol hexa(meth)acrylate, and the like.

Also, a polyether acrylic oligomer and a polyester acrylic oligomer having polyether and polyester in the main chain respectively, and a polyepoxy acrylic oligomer can be used.

Examples of (meth) acrylate having one (meth) acryloyl group and having a boiling point of 130 degree C or higher under 0.1 MPa include dimethylaminoethyl (meth)acrylate, acryloylmorpholine, dimethylacrylamide, diethylacrylamide, diisopropylacrylamide, diacetone acrylamide, isobutoxymethyl (meth)acrylamide, N-vinylpyrrolidone, N-vinylcaprolactam, isobornyl (meth)acrylate, dicyclopentenyl acrylate, dicyclopentanyl (meth)acrylate, dicyclopentenyloxyethyl (meth)acrylate, 3-hydroxy-1-adamantyl (meth)acrylate, methyl (meth)acrylate, ethyl (meth)acrylate, n-butyl (meth)acrylate, isobutyl (meth)acrylate, cyclohexyl (meth)acrylate, isoamyl (meth)acrylate, isooctyl (meth)acrylate, lauryl (meth)acrylate, stearyl (meth)acrylate, benzyl (meth)acrylate, dicyclopentadienyl (meth)acrylate, tricyclodecanyl (meth)acrylate, 2-acryloylcyclohexyl succinate, tetrahydrofurfuryl (meth)acrylate, 2-hydroxy-3-phenoxypropyl (meth) acrylate, butoxyethyl (meth) acrylate; (meth) acrylate of an alcohol which is an ethylene oxide adduct of C1 to C8 alkyl alcohol, ethylene oxide adduct of phenol, ethylene oxide adduct of p-cumylphenol, or ethylene oxide adduct of nonylphenol; o-phenylphenol glycidyl ether (meth)acrylate, 2-hydroxyethyl (meth)acrylate, 2-hydroxypropyl (meth)acrylate, 2-hydroxybutyl (meth)acrylate, 2-methoxyethyl (meth)acrylate, 2-ethoxyethyl (meth)acrylate, 4-hydroxybutyl (meth)acrylate, 2-phenoxyethyl (meth)acrylate, ethyl carbitol (meth)acrylate, 2-ethylhexyl (meth)acrylate, 3-hydroxycyclohexyl acrylate, tribromophenolethoxy (meth)acrylate, 2,2,2-trifluoromethyl (meth)acrylate, 2,2,3,3-tetrafluoropropyl (meth)acrylate, 1H,1H,5H-octafluoropentyl (meth)acrylate, perfluorooctylethyl (meth)acrylate, and the like.

The compounds described above are available as commercial compounds under the trade names of Yupimer UV SA1002, SA2007 (manufactured by Mitsubishi Chemical Corporation); Viscoat#150, #155, #160, #190, #192, #195, #230, #215, #260, #295, #300, #335HP, #360, #400, #540, #700, 3F, 3FM, 4F, 8F, 8FM, 2-MTA, 2-ETA, V-MTG, 3PA, GPA, HEA, HPA, 4-HBA, AIB, IOAA, LA, STA (manufactured by OSAKA ORGANIC CHEMICAL INDUSTRY LTD.); LIGHT-ESTER M, E, NB, IB, EH, ID, L, L-7, TD, L-8, S, 130MA, 041MA, CH, THF, BZ, PO, IB-X, HO, HOP, HOA, HOP-A, HOB, DM, DE, HO-MS, EG, 2EG, 1.4BG, 1.6HX, 1.9ND, 1.10DC, TMP, G-101P, G-201P, BP-2EM, BP-4EM, BP-6EM, MTG, BO, BC, 3EG, 4EG, 9EG, 14EG, NP, FM-108, G-201P, LIGHT-ACRYLATE IO-A, HOB-A, TMP-3EO-A, FA-108, IAA, L-A, S-A, BO-A, EC-A, MTG-A, 130A, DPM-A, PO-A, P-200A, NP-4EA, NP-8EA, THF-A, IB-XA, HOA, HOP-A, M-600A, HOA-MS, 3EG-A, 4EG-A, 9EG-A, 14EG-A, NP-A, MPD-A, 1.6HX-A, BEPG-A, 1.9ND-A, MOD-A, DCP-A, BP-4EA, BP-4PA, BP-10EA, TMP-A, TMP-6EO-3A, PE-3A, PE-4A, DPE-6A, BA-104, BA-134 (manufactured by KYOEISYA CHEMICAL Co.,LTD); KAYARAD MANDA, HX-220, HX-620, R-551, R-712, R-604, R-684, PET-30, GPO-303, TMPTA, DPHA, D-310, D-330, DPCA-20, 30, 60, 120 (manufactured by NIPPON KAYAKU CO., LTD.) ; ARONIX M208, M210, M215, M220, M240, M315, M309, M310, M315, M325, M400, M1200, M6100, M6200, M6250, M7100, M8030, M8060, M8100, M8530, M8560, M9050 (manufactured by TOAGOSEI CO., LTD.); NK ESTER#410P, NK ESTER A-BPEF, NK ESTER A-CMP-AE (manufactured by SHIN-NAKAMURA CHEMICAL CO.,LTD.); New Frontier BR-31 (manufactured by DAI-ICHI KOGYO SEIYAKU CO., LTD.); Ripoxy VR-77, VR-60, VR-90 (manufactured by SHOWA HIGHPOLYMER CO., LTD.); Ebecry181, 83, 600, 629, 645, 745, 754, 767, 701, 755, 705, 770, 800, 805, 810, 830, 450, 1830, 1870 (manufactured by Daicel UCB Co., Ltd.); BEAM SET575, 551B, 502H, 102 (manufactured by Arakawa Chemical Industries,Ltd.); Adamantate HA, HM (manufactured by Idemitsu Kosan Co.,Ltd.); and the like.

Such component (c) can be used singly or in combination of two or more.

The amount of component (C) is preferably 5 to 100 mass parts, more preferably 10 to 70 mass parts, most preferably 20 to 50 mass parts, per 100 mass parts of component (A). When the amount is less than 5 mass parts, in the manufacture of an optical waveguide, the waveguide sometimes has poor dimensional accuracy. When the amount exceeds 100 mass parts, component (C) has poor compatibility with component (A), so that the surface of the cured material sometimes becomes rough.

### [Component (D)]

Component (D) is a photo-radical polymerization initiator which can be irradiated with radiation (e.g. light) to generate an active substance (i.e. radical) capable of polymerizing ethylenically unsaturated groups.

Here, examples of the radiation include infrared rays, visible light, UV rays, and ionizing radiation such as X rays, electron rays, alpha rays, beta rays, gamma rays.

Examples of the photo-radical polymerization initiator include acetophenone, acetophenone benzyl ketal, 1-hydroxycyclohexyl phenyl ketone, 2,2-dimethoxy-2-phenylacetophenone, xanthone, fluorenone, benzaldehyde, fluorene, anthraquinone, triphenylamine, carbazole, 3-methylacetophenone, 4-chlorobenzophenone, 4,4'-dimethoxybenzophenone, 4,4'-diaminobenzophenone, Michler's ketone, benzoin propyl ether, benzoin ethyl ether, benzyl dimethyl ketal, 1-(4-isopropylphenyl)-2-hydroxy-2-methylpropane-1-one, 2-hydroxy-2-methyl-1-phenylpropane-1-one, thioxanthone, diethylthioxanthone, 2-isopropylthioxanthone, 2-chlorothioxanthone, 2-methyl-1-[4-(methylthio)phenyl]-2-morpholino-propane-1-one, 2,4,6-trimethylbenzoyldiphenylphosphine oxide, bis(2,6-dimethoxybenzoyl)-2,4,4-trimethylpentylphosphine oxide, and the like.

The photo-radical polymerization initiators are available as commercial compounds under the trade names of Irgacure 184, 369, 651, 500, 819, 907, 784, 2959, CGI1700, CGI1750, CGI11850, CG24-61, Darocur1116, 1173 (manufactured by Ciba Specialty Chemicals); LucirinTPO, TPO-L (manufactured by BASF Corporation); Ubecryl P36 (manufactured by UCB); and the like.

Such photo-radical polymerization initiator can be used singly or in combination of two or more.

Component (D) is included in an amount of preferably from 0.1 to 10 mass percent, more preferably from 0.2 to 5 mass percent, in the radiation-sensitive resin composition of the present invention. When the amount is less than 0.1 mass percent, the composition is not sufficiently cured, so that the optical waveguide sometimes has a trouble with transmission characteristics. When the amount exceeds 10 mass percent, the photo polymerization initiator is likely to have adverse effect on the transmission characteristics after a long period of time.

In the present invention, a photosensitizer can be added with the photo polymerization initiator described above. By concomitant use of a photosensitizer, an energy ray such as light can be more effectively adsorbed.

Examples of such photosensitizers include thioxanthone, diethylthioxanthone, and thioxanthone derivatives; anthraquinone, bromoanthraquinone, and anthraquinone derivatives; anthracene, bromoanthracene, and anthracene derivatives; perylene, and perylene derivatives; xanthone, thioxanthone, and thioxanthone derivatives; coumarin, and ketocoumarin; and the like. The type of the photosensitizer may be selected depending on the type of the photo polymerization initiator.

Moreover, it is preferable for the radiation-sensitive resin composition of the present invention to further contain an organic solvent as component (E) . By including an organic solvent, the radiation-sensitive resin composition can have improved storage stability and appropriate viscosity, so that an optical waveguide having a uniform thickness can be formed.

Although the type of the organic solvent can be selected as appropriate provided that the objects and the effects of the present invention retains, it is preferable to use an organic solvent which has a boiling point of 50 to 200 degree C at atmospheric pressure and can dissolve the constituent components uniformly. Specifically, the organic solvent used for preparing component (A) can be employed as component (E).

Preferred examples of the organic solvent include alcohols, ethers, esters, and ketones. Preferably, the organic solvent includes at least one compound selected from the group consisting of propylene glycol monomethyl ether acetate, propylene glycol monomethyl ether, ethyl lactate, diethylene glycol dimethyl ether, methyl isobutyl ketone, methyl amyl ketone, cyclohexanone, toluene, xylene, and methanol.

The amount of the organic solvent to be added is preferably from 10 to 500 mass parts, more preferably from 20 to 300 mass parts, most preferably from 30 to 180 mass parts, per 100 mass parts of the total amount of components (A) to (D) . When the amount is less than 10 mass parts, it is sometimes difficult to adjust the viscosity of the radiation-sensitive resin composition. When the amount exceeds 500 mass parts, it is sometimes difficult to form an optical waveguide having a sufficient thickness.

In addition to components (A) to (E) described above, the resin composition of the present invention may further contain, for example, a compound having one polymerizable reaction group in its molecule; polymer resins such as epoxy resin, acrylic resin, polyamide resin, polyamideimide resin, polyurethane resin, polybutadiene resin, polychloroprene resin, polyether resin, polyester resin, styrene-butadiene block copolymer, petroleum resin, xylene resin, ketone resin, cellulose resin, fluorine polymer, silicone polymer; and the like, if the need arises provided that the composition of the present invention retains its characteristics.

Moreover, it is possible to add various additives as needed, such as an antioxidant, UV absorber, light stabilizer, silane coupling agent, coating surface improver, thermal polymerization inhibitor, leveling agent, surfactant, colorant, storage stabilizer, plasticizer, lubricant, filler, inorganic particle, antiaging agent, wetting agent, antistatic agent, and the like

Here, the antioxidants are available as commercial compounds under the trade names of Irganox 1010, 1035, 1076, 1222 (manufactured by Ciba Specialty Chemicals); Antigene P, 3C, FR, Sumilizer (manufactured by Sumitomo Chemical Co.,Ltd); and the like. The UV absorbers are available as commercial compounds under the trade names of Tinuvin P, 234, 320, 326, 327, 328, 329, 213 (manufactured by Ciba Specialty Chemicals) ; Seesorb 102, 103, 110, 501, 202, 712, 704 (manufactured by SHIPRO KASEI KAISHA, LTD.); and the like. The light stabilizers are available as commercial compounds under the trade names of Tinuvin 292, 144, 622LD (manufactured by Ciba Specialty Chemicals); SANOL LS770 (manufactured by Sankyo Co., Ltd.); Sumisorb TM-061 (manufactured by Sumitomo Chemical Co., Ltd); and the like. Examples of the silane coupling agent include γ-aminopropyltriethoxysilane, γ-mercaptopropyltrimethoxysilane, γ-(meth)acryloxypropyltrimethoxysilane, and the like. The silane coupling agents can also be commercially available under the trade names of SH6062, SZ6030 (manufactured by Dow Corning Toray Silicone Co.,Ltd.); KBE903, 603, 403 (manufactured by Shin-Etsu Chemical Co., Ltd.); and the like. Examples of the coating surface improver include a silicone additive such as dimethylsiloxane polyether; and the like. The coating surface improvers can also be commercially available under the trade names of DC-57, DC-190 (manufactured by Dow Corning Corporation); SH-28PA, SH-29PA, SH-30PA, SH-190 (manufactured by Dow Corning Toray Silicone Co., Ltd.); KF351, KF352, KF353, KF354 (manufactured by Shin-Etsu Chemical Co., Ltd.); L-700, L-7002, L-7500, FK-024-90 (manufactured by Nippon Unicar Company Limited); and the like.

To prepare the radiation-sensitive resin composition of the present invention, the components described above may be mixed and stirred in the usual manner.

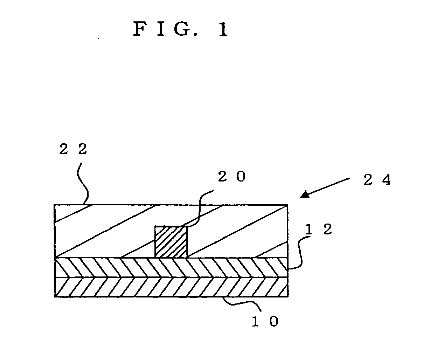

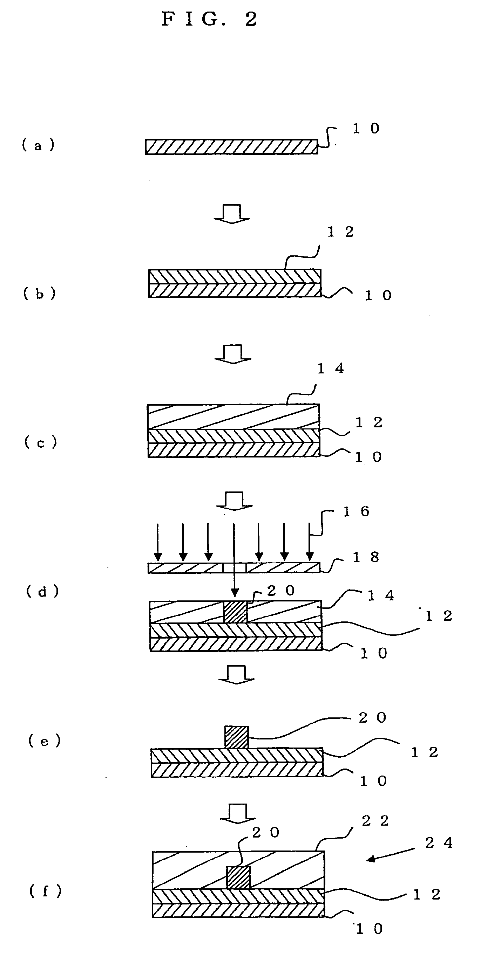

An example of an optical waveguide formed using the radiation-sensitive resin composition of the present invention will now be described with reference to the drawings as appropriate. FIG. 1 is a sectional view schematically illustrating an example of an optical waveguide of the present invention. FIG. 2 is a flow diagram illustrating an example of a method for manufacturing an optical waveguide of the present invention.

### [1.Structure of optical waveguide]

In FIG. 1, the optical waveguide 24 shows a part of an optical waveguide having a form of film (i.e. waveguide film), and includes a lower clad layer 12 to be fixed to a support 10 when used, a core portion 20 having a specific width formed on the upper surface of the lower clad layer 12, and an upper clad layer 22 formed by being laminated on the core portion 20 and the lower clad layer 12. The core portion 20 is covered with the lower clad layer 12 and the upper clad layer 22 which form the outer shape of the optical waveguide 24.

There are no particular limitations on the thicknesses of the lower clad layer, the core portion, and the upper clad layer, but for example, the lower clad layer has a thickness of 1 to 200 µm, the core portion has a thickness of 3 to 200 µm, and the upper clad layer has a thickness of 1 to 200 µm. There are no particular limitations on the width of the core portion, but for example, the core portion has a width of 1 to 200 µm.

It is necessary for the core portion to have a refractive index higher than the respective refractive indexes of the lower clad layer and the upper clad layer. For example, for light having a wavelength of 400 to 1,600 nm, it is preferable that each of the lower clad layer and the upper clad layer has a refractive index of 1.400 to 1.648, and that the core portion has a refractive index of 1.420 to 1.650 which is at least 0.1% higher than the respective refractive indexes of the two clad layers.

### [2. Method for manufacturing optical waveguide]

The method for manufacturing the optical waveguide 24 of the present invention includes a step for forming the lower clad layer 12 on the support 10, a step for forming the core portion 20, and a step for forming the upper clad layer 22. Among the three steps, at least one step is a step in which the radiation-sensitive resin composition described above is irradiated with radiation to form a cured product.

The radiation-sensitive resin compositions for forming the lower clad layer 12, the core portion 20, and the upper clad layer 22 are referred to as lower layer composition, core composition, upper layer composition respectively for convenience.

### (1) Preparation of radiation-sensitive resin compositions

The component compositions of the lower layer composition, the core composition, and the upper layer composition are determined such that the relationship between the refractive indexes of the lower clad layer 12, the core portion 20, and the upper clad layer 22 satisfies the condition required for the optical waveguide. In more detail, two or three radiation-sensitive resin compositions having appropriately different refractive indexes are prepared, and the radiation-sensitive resin composition which gives a cured film of the highest refractive index is employed as the core composition, and the other compositions are employed as the lower layer composition and the upper layer composition.

The lower layer composition and the upper layer composition are preferably the same radiation-sensitive resin composition in view of cost and manufacturing control.

The radiation-sensitive resin composition has a viscosity of preferably from 1 to 10, 000 cps (at 25 degree C), more preferably from 5 to 8,000 cps (at 25 degree C), and most preferably from 10 to 5,000 cps (at 25 degree C). When the viscosity is outside the above range, it is sometimes difficult to handle the radiation-sensitive resin composition or to form a uniform coating film. The viscosity can be adjusted as appropriate by adjusting the added amount of the organic solvent.

### (2) Preparation of support

A support having a flat surface is prepared. Examples of the support include, but are not limited to, a silicon support, glass support, and the like.

### (3) Step for forming lower clad layer

This step is a step in which the lower clad layer 12 is formed on the surface of the support. In more detail, as shown in FIG. 2 (b), the lower layer composition is applied onto the support 10, and then, dried or pre-baked to form a thin film for the lower clad layer. The thin film for the lower clad layer is irradiated with radiation to be a cured product, thus forming the lower clad layer 12. It is preferable that, in the step for forming the lower clad layer, the entire thin film is irradiated to be cured thoroughly.

As a method of applying the lower layer composition, any method selected from among a spin coating method, a dipping method, a spraying method, a bar coating method, a roll coating method, a curtain coating method, a gravure printing method, a silk screen method, and an ink jet method can be employed. Of these, the spin coating method is preferably used, because a thin film having a uniform thickness for the lower clad layer can be obtained. Moreover, to make the rheological properties of the lower layer composition suitably match the application method, it is preferable to blend in various optional components such as leveling agents, thixotropy-bestowing agents, fillers, organic solvents, surfactants and so on as required.

Moreover, after the application, it is preferable to pre-bake the thin film for the lower layer made of the lower layer composition at a temperature of 50 to 200 degree C, in order to remove the organic solvent and the like.

The method for the application, or the method for improving the rheological properties in the step for forming the lower clad layer can be applied to the step for forming the core portion and the step for forming the upper clad layer described below.

There are no particular limitations on the irradiation dose of the radiation when forming the lower clad layer, but the target (i.e. the lower layer composition) is preferably exposed to radiation having a wavelength of 200 to 450 nm and an intensity of 1 to 500 mW/cm² at a radiation dose of 0.01 to 5,000 mJ/cm².

Examples of the radiation (e.g. light) include visible light, UV rays, infrared rays, X rays, alpha rays, beta rays, gamma rays, and the like. Of these, UV rays are most preferred. It is preferable to use an irradiation apparatus such as a high-pressure mercury vapor lamp, low-pressure mercury vapor lamp, metal halide lamp, excimer lamp, and the like.

It is also preferable to perform a heating treatment (i.e. post-bake) after the exposure. The heating treatment is performed under various heating conditions depending on the component composition of the radiation-sensitive resin composition or the like, but it is preferable to set the heating time, for example, in the range of 5 minutes to 72 hours, usually at a temperature of 30 to 400 degree C, preferably of 50 to 300 degree C, more preferably of 100 to 200 degree C. By post-baking, the entire thin film can be thoroughly cured.

The irradiation dose, the type, or the irradiation apparatus of the radiation in the step for forming the lower clad layer can also be applied to the step for forming the core portion and the step for forming the upper clad layer described below.

### (4) Step for forming core portion

Next, as shown in FIG.2 (c), the core composition is applied onto the lower clad layer 12, and then, dried or pre-baked, to form a thin film for the core portion 14.

Next, as shown in FIG. 2 (d), the upper surface of the thin film for the core portion 14 is irradiated (i.e. exposed) with radiation 16 in a prescribed pattern, for example, via a photo-mask 18 having a prescribed line pattern. By the irradiation, the irradiated parts of the thin film for the core portion 14 are cured. The other parts, that is the uncured parts, are then developed to be removed, so that the core portion 20 composed of a patterned cured film can be formed on the lower clad layer 12, as shown in FIG.2 (e).

The detail of the developing in this step is as follows.

In the developing of the thin film including the cured parts selectively cured by the exposure in a prescribed pattern and the uncured parts, only the uncured parts are removed using a developer, utilizing the difference in resolvability between the cured parts and the uncured parts. That is, after the patterned exposure, the uncured parts are removed while leaving behind the cured parts, thus forming the core portion.

An organic solvent can be used as the developer for the developing. Examples of the organic solvent include acetone, methanol, ethanol, isopropyl alcohol, ethyl lactate, propylene glycol monomethyl ether acetate, methyl amyl ketone, methyl ethyl ketone, cyclohexanone, propylene glycol monomethyl ether, and the like.

Generally, the developing is carried out for 30 to 600 seconds. Any of publicly known developing methods such as a puddle developing method, dipping method, shower developing method, and the like can be employed. After the developing, the target is directly air-dried to evaporate the organic solvent, whereby a patterned thin film is formed.

After the patterned thin film (i.e. patterned part) is formed, the patterned part is heat-treated (i.e. post-baked). The heating is performed under various heating conditions depending on the component composition of the radiation-sensitive resin composition or the like, but it is preferable to set the heating time, for example, in the range of 5 minutes to 10 hours, usually at a temperature of 30 to 400 degree C, preferably of 50 to 300 degree C, more preferably of 100 to 200 degree C. By post-baking, the entire thin film can be thoroughly cured.

In this step, the method of irradiating radiation in a prescribed pattern is not limited to the method using the photo-mask 18 having a light-transmitting part and a non-light-transmitting part, and for example, any of the following methods "a" to "c" may be employed.
a. A method of using means for electro-optically forming a mask image composed of a light-transmitting part and a non-light-transmitting part in a prescribed pattern using the same principle as a liquid crystal display apparatus.
b. A method of using a light guiding member composed of bundled optical fibers, and irradiating radiation through an optical fiber corresponding to a prescribed pattern of the light guiding member.
c. a method in which laser beam, or convergent light obtained by such concentrating optical system such as a lens, a mirror, and the like is irradiated onto the radiation-sensitive resin composition while being scanned.

### (5) Step for forming upper clad layer

The upper layer composition is applied onto the surface of the core portion 20 and the lower clad layer 12, and then, dried or pre-baked to form a thin film for the upper clad layer. The thin film for the upper clad layer is irradiated with radiation to be cured, thus forming the upper clad layer 22 as shown in FIG. 2 (f).

Next, the upper clad layer 22 is heat-treated (i.e. post-baked).

The upper clad layer 22 is heated in various conditions depending on the component composition of the radiation-sensitive resin composition or the like, but it is preferable to set the heating time, for example, in the range of 5 minutes to 72 hours, usually at a temperature of 30 to 400 degree C, preferably of 50 to 300 degree C, more preferably of 100 to 200 degree C. By heat-treatment (i.e. post-baking), the entire thin film can be thoroughly cured.

### (6) Step for forming a cured film

The cured product manufactured by the steps (1) to (4) described above is separated from the support 10, thus obtaining a film of the optical waveguide (i.e. waveguide film).

An example of a method for separating includes a method of soaking the optical waveguide manufactured on a silicon support in warm water or hydrofluoric acid. The obtained waveguide film can be advantageously used not only in the same application as those of publicly known silica optical waveguides but also in applications on optical transmission communication between devices through a flexible part such as a hinge of a flip phone and a hinge of a notebook computer.

### Examples

The present invention will now be explained more specifically with reference to the following Examples.

### [1. Preparation of material]

The following materials are prepared as components (A) to (E).

### (1) Component (A)

### Preparation example 1

After the system of a flask equipped with a dry ice/methanol reflux tube was purged with nitrogen, 3 g of 2,2'-azobisisobutyronitrile as a polymerization initiator, 115 g of propylene glycol monomethyl ether acetate as an organic solvent were put into the flask, and then, stirred until the polymerization initiator was dissolved. Next, 20 g of hydroxyethyl methacrylate, 30 g of dicyclopentanyl acrylate, 25 g of styrene, and 25 g of n-butyl acrylate were put into the flask, and stirring started slowly. The solution was then heated to a temperature of 80 degree C, and the polymerization was carried out for 6 hours at the temperature. Next, after 0.13 g of di-n-butyltin dilaurate and 0.05 g of 2, 6-di-t-butyl-p-cresol were added to the obtained solution, 23.7 g of 2-methacryloxyethyl isocyanate was dropped while stirring at a temperature below 60 degree C. The reaction was then carried out for 5 hours at a temperature of 60 degree C, thus obtaining a polymer solution having a methacryl group in the side chain. Then, the reaction product was added into a large amount of hexane to coagulate the reaction product. Moreover, this coagulated material was resolved into the same amount of tetrahydrofuran, and then the solution was added into a large amount of hexane to be recoagulated. The resolution-recoagulation process was carried out a total of three times, and the obtained coagulated material was then dried in a vacuum for 48 hours at a temperature of 40 degree C, thus obtaining the objective copolymer A-1. Copolymer A-1 has a number average molecular weight (Mn) of 4, 800 and a weight average molecular weight (Mw) of 25, 500 in terms of polystyrene, as measured by gel permeation chromatography.

### Preparation example 2

After the system of a flask equipped with a dry ice/methanol reflux tube was purged with nitrogen, 3 g of 2,2'-azobisisobutyronitrile as a polymerization initiator, 150 g of ethyl lactate as an organic solvent were put into the flask, and then, stirred until the polymerization initiator was dissolved. Next, 20 g of methacrylic acid, 30 g of dicyclopentanyl acrylate, 25 g of styrene, and 25 g of n-butyl acrylate were put into the flask, and stirring started slowly. The solution was then heated to a temperature of 80 degree C, and the polymerization was carried out for 6 hours at the temperature. Next, 10.5 g of 3,4-epoxycyclohexylmethyl acrylate, 0.8 g of tetrabutylammonium bromide, and 0.1 g of p-methoxyphenol were added to the obtained solution, and heated for 7 hours at a temperature of 80 degree C, thus obtaining a polymer solution having an acryl group in the side chain. Then, the reaction product was added into a large amount of hexane to coagulate the reaction product. Moreover, this coagulated material was resolved into the same amount of tetrahydrofuran, and then the solution was added into a large amount of hexane to be recoagulated. The resolution-recoagulation process was carried out a total of three times, and the obtained coagulated material was then dried in a vacuum for 48 hours at a temperature of 40 degree C, thus obtaining the objective copolymer A-2. Copolymer A-2 has a number average molecular weight (Mn) of 5, 500 and a weight average molecular weight (Mw) of 18, 000 in terms of polystyrene, as measured by gel permeation chromatography.

### Preparation example 3

After the system of a flask equipped with a dry ice/methanol reflux tube was purged with nitrogen, 1.5 g of 2,2'-azobis(2,4-dimethylvaleronitrile) as a polymerization initiator, 115 g of propylene glycol monomethyl ether acetate as an organic solvent were put into the flask, and then, stirred until the polymerization initiator was dissolved. Next, 20 g of hydroxyethyl methacrylate, 25 g of dicyclopentanyl acrylate, 40 g of methyl methacrylate, and 15 g of n-butyl acrylate were put into the flask, and stirring started slowly. The solution was then heated to a temperature of 70 degree C, and the polymerization was carried out for 6 hours at the temperature. After 0.12 g of di-n-butyltin dilaurate and 0.05 g of 2,6-di-t-butyl-p-cresol were added to the obtained solution, 23. 7 g of 2-methacryloxyethyl isocyanate was dropped while stirring at a temperature below 60 degree C. The reaction was then carried out for 5 hours at a temperature of 60 degree C, thus obtaining a polymer solution having a methacryl group in the side chain. Then, the reaction product was added into a large amount of hexane to coagulate the reaction product. Moreover, this coagulated material was resolved into the same amount of tetrahydrofuran, and then the solution was added into a large amount of hexane to be recoagulated. The resolution-recoagulation process was carried out a total of three times, and the obtained coagulated material was then dried in a vacuum for 48 hours at a temperature of 40 degree C, thus obtaining the objective copolymer A-3. Copolymer A-3 has a number average molecular weight (Mn)of 6,400 and a weight average molecular weight (Mw) of 20,800 in terms of polystyrene, as measured by gel permeation chromatography.

### Preparation example 4

After the system of a flask equipped with a dry ice/methanol reflux tube was purged with nitrogen, 1 g of 2,2'-azobis(2,4-dimethylvaleronitrile) as a polymerization initiator, 150 g of ethyl lactate as an organic solvent were put into the flask, and then, stirred until the polymerization initiator was dissolved. Next, 20 g of methacrylic acid, 25 g of dicyclopentanyl acrylate, 35 g of methyl methacrylate, and 20 g of n-butyl acrylate were put into the flask, and stirring started slowly. The solution was then heated to a temperature of 70 degree C, and the polymerization was carried out for 6 hours at this temperature. 31.4 g of 3,4-epoxycyclohexylmethyl acrylate, 2.2 g of tetrabutylammonium bromide, and 0.1 g of p-methoxyphenol were added to the obtained solution, and then, heated for 7 hours at a temperature of 80 degree C, thus obtaining a polymer solution having an acryl group in the side chain. Then, the reaction product was added into a large amount of hexane to coagulate the reaction product. Moreover, this coagulated material was resolved into the same amount of tetrahydrofuran, and then the solution was added into a large amount of hexane to be recoagulated. The resolution-recoagulation process was carried out a total of three times, and the obtained coagulated material was then dried in a vacuum for 48 hours at a temperature of 40 degree C, thus obtaining the objective copolymer A-4. Copolymer A-4 has a number average molecular weight (Mn)of 11,000 and a weight average molecular weight (Mw) of 35, 500 in terms of polystyrene, as measured by gel permeation chromatography.

The names and the added amounts of the materials described above used in the manufacture of the copolymers A-1 to A-4 are given in Table 1.

**[Table 1]**

| | unit : g | A-1 | A-2 | A-3 | A-4 |
|---|---|---|---|---|---|
| monomer | hydroxyethyl methacrylate | 20 | | 20 | |
| | methacrylic acid | | 20 | | 20 |
| | dicyclopentanyl acrylate | 30 | 30 | 25 | 25 |
| | styrene | 25 | 25 | | |
| | n-butyl acrylate | 25 | 25 | 15 | 20 |
| | methyl methacrylate | | | 40 | 35 |
| reactivity giving component | 2-methacryloxyethyl isocyanate | 23.7 | | 23.7 | |
| | 3,4-epoxycyclohexylmethyl acrylate | | 10.5 | | 31.4 |

### (2) Component (B)

13.6 mass parts of isophorone diisocyanate, 81.7 mass parts of polypropylene glycol having a number average molecular weight of 2,000, and 0.01 mass part of 2, 6-di-t-butyl-p-cresol were put into a reaction vessel equipped with a stirrer, and cooled down to a temperature of 5 to 10 degree C. Next, 0.05 mass part of di-n-butyltin dilaurate was added while stirring, and stirred for 2 hours at a temperature below 30 degree C, then heated to a temperature of 50 degree C, and further, stirred for 2 hours. Next, after 4.7 mass parts of 2-hydroxyethyl acrylate was added (the total amount of the above-mentioned compounds: 100 mass parts), the reaction was then carried out for 1 hour at a temperature of 50 to 70 degree C. The reaction was terminated when the residual amount of isocyanate was reduced to 0.1 mass% or less, thus obtaining a compound B-1. Compound B-1 has a number average molecular weight (Mn)of 7,000 and a weight average molecular weight (Mw) of 13, 000 in terms of polystyrene, as measured by gel permeation chromatography.

### (3) Component (C)

Trimethylolpropane triacrylate (boiling point under 0.1 MPa: 315 degree C; manufactured by OSAKA ORGANIC CHEMICAL INDUSTRY LTD.)

Tribromophenolethoxy acrylate (melting point: about 50 degree C; New Frontier BR-31, manufactured by DAI-ICHI KOGYO SEIYAKU CO., LTD.)

Tetrafluoropropyl acrylate (boiling point under 21 kPa: 106 degree C; Viscoat 4F, manufactured by OSAKA ORGANIC CHEMICAL INDUSTRY LTD.)

### (4) Component (D)

Photo-radical polymerization initiator (trade name 'Irgacure369', manufactured by Ciba Specialty Chemicals)

### (5) Component (E)

Ethyl lactate
Propylene glycol monomethyl ether acetate

### [2. Preparation of radiation-sensitive resin composition]

Component (A) (i.e. copolymers A-1 to A-4), and components (B) to (E) were blended in the ratio shown in Table 2, and mixed uniformly, thus obtaining radiation-sensitive resin compositions J-1 to J-8.

**[Table 2]**

| | | J-1 | J-2 | J-3 | J-4 | J-5 | J-6 | J-7 | J-8 |
|---|---|---|---|---|---|---|---|---|---|
| unit : parts by mass | | for core portion | | | | for clad layer | | | |
| component A | A-1 | 100 | 100 | 100 | - | - | - | - | - |
| | A-2 | - | - | - | 100 | - | - | - | - |
| | A-3 | - | - | - | - | 100 | 100 | 100 | - |
| | A-4 | - | - | - | - | - | - | - | 100 |
| component B | B-1 | 43 | 43 | - | 43 | 43 | 43 | - | 43 |
| component C | Trimethylolpropane triacrylate | 43 | - | 20 | 71 | 43 | - | 30 | 70 |
| | New Frontier BR-31 | - | 43 | - | - | - | - | - | - |
| | Viscoat 4F | - | - | - | - | - | 43 | - | - |
| component D | Irgacure 369 | 3 | 3 | 3 | 3 | 3 | 3 | 3 | 3 |
| component E | Ethyl lactate | - | - | - | 200 | - | - | - | 190 |
| | Propylene glycol monomethyl ether acetate | 90 | 90 | 90 | - | 95 | 105 | 95 | - |
| total | | 279 | 279 | 213 | 417 | 284 | 294 | 228 | 406 |

### [3. Formation of optical waveguide]

### [Example 1]

### (a) Formation of lower clad layer

The radiation-sensitive resin composition J-5 was applied onto a silicon support using a spin coater, and then, pre-baked for 10 minutes at a temperature of 100 degree C using a hot plate. Next, the coating film composed of the radiation-sensitive resin composition J-5 was irradiated with radiation having a wavelength of 365 nm and an intensity of 10 mW/cm² for 100 seconds to be cured. The cured film was then post-baked for 1 hour at a temperature of 150 degree C, thus forming a lower clad layer having a thickness of 50 µm.

### (b) Formation of core portion

Next, the radiation-sensitive resin composition J-1 was applied onto the lower clad layer using a spin coater to form a coating film, and then, pre-baked for 10 minutes at a temperature of 100 degree C. The coating film, which has a thickness of 50 µm and is composed of the radiation-sensitive resin composition J-1, was then irradiated with radiation having a wavelength of 365 nm and an intensity of 10 mW/cm² for 100 seconds via a photo-mask which has a 50 µm-width line pattern, so that the coating film was partially cured. Next, the support having the cured coating film was soaked into a developer of acetone, so that the unexposed parts of the coating film were removed. Post-baking was then carried out for 1 hour at a temperature of 150 degree C, thus forming a core portion having a 50 µm-width line pattern.

### (c) Formation of upper clad layer

Next, the radiation-sensitive resin composition J-5 was applied onto the lower clad layer and the core portion thereon using a spin coater, and then, pre-baked for 10 minutes at a temperature of 100 degree C using a hot plate. The coating film composed of the radiation-sensitive resin composition J-5 was irradiated with radiation having a wavelength of 365 nm and an intensity of 10 mW/cm² for 100 seconds, thus forming an upper clad layer having a thickness of 50 µm.

### [Examples 2 to 4 and Comparative Examples 1 and 2]

Optical waveguides were manufactured by the same process as Example 1, excepting that the radiation-sensitive resin compositions shown in Table 1 were employed instead of the radiation-sensitive resin composition of Example 1.

### [4. Evaluation of optical waveguide]

Each of the optical waveguides (Examples 1 to 4 and Comparative Examples 1 and 2) was evaluated as follows.

### (1) Dimensional accuracy of optical waveguide

The core portion was designed to be 50µm high and 50µm wide. The case that the core portion actually had a height of 50±5µm and a width of 50±5µm was taken as "o", and the case not in the above case was taken as "x"

### (2) Waveguide loss

Radiation having a wavelength of 850 nm was inputted into one end of the optical waveguide. The amount of light outgoing from the other end was then measured, and the waveguide loss per unit length was obtained using a cut-back method. The case that the waveguide loss was 0.5 db/cm or less was taken as "o", and the case that the waveguide loss exceeded 0.5 db/cm was taken as "×".

### (3) Bending resistance

The optical waveguide, which was formed to have the lower clad layer of 20µm-height, the core portion of 50µm-height, and the upper clad layer which was 20µm high from the upper surface of the core portion, was separated from the support, thus obtaining a waveguide film having a width of 1 cm, a length of 10 cm, and a thickness of 90µm. When the waveguide film winds around a metal bar having a radius of 2 mm at a temperature of 23 degree C and with a humidity of 50 %, the case that the optical waveguide did not crack or rupture was taken as "o", the case that the optical waveguide cracks or ruptures was taken as "x".

The results were shown in Table 3.

**[Table 3]**

| | Example 1 | Example 2 | Example 3 | Example 4 | Comparative Example 1 | Comparative Example 2 |
|---|---|---|---|---|---|---|
| [Structure of waveguide] Lower clad layer | J-5 | J-6 | J-6 | J-8 | J-7 | J-7 |
| Core portion | J-1 | J-2 | J-1 | J-4 | J-3 | J-1 |
| Upper clad layer | J-5 | J-6 | J-6 | J-8 | J-7 | J-7 |
| [Characteristics of waveguide] imensional accuracy of core portion | ○ | ○ | ○ | ○ | ○ | ○ |
| Waveguide loss | ○ | ○ | ○ | ○ | ○ | ○ |
| Bending resistance | ○ | ○ | ○ | ○ | × | × |

Table 3 shows that the optical waveguides manufactured using the radiation-sensitive resin compositions of the present invention (i.e. Examples 1 to 4) have high dimensional accuracy for the core portion, good transmission characteristics (i.e. low waveguide loss), and excellent bending resistance. On the other hand, Table 3 shows that the optical waveguides manufactured using the radiation-sensitive resin compositions not belonging to the present invention (i.e. Comparative Examples 1 and 2) cracked or ruptured when bended, and were poor in bending resistance.

## Claims

1. A radiation-sensitive resin composition for optical waveguides, comprising:
(A) a polymer having a repeating unit represented by the following general formula (1) 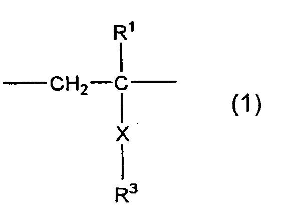 (in the formula, R¹ is a hydrogen atom or a methyl group, R³ is a (meth)acryloyl group, X is a bivalent organic group);
(B) a urethane (meth) acrylate compound which is a reaction product of a polyester polyol compound, a polyisocyanate compound, and a (meth)acrylate having a hydroxyl group;
(C) a compound having at least one ethylenically unsaturated group and having a boiling point of 130 degree C or higher under 0.1 MPa other than the components (A) and (B); and
(D) a photo-radical polymerization initiator.

2. The radiation-sensitive resin composition according to Claim 1, wherein the general formula (1) represents a structure represented by the following general formula (3) 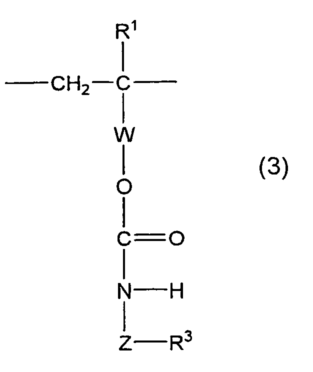 (in the formula, R¹ is a hydrogen atom or a methyl group, R³ is a (meth)acryloyl group, W and Z are each independently a single bond or a bivalent organic group).

3. The radiation-sensitive resin composition according to Claim 1, wherein component (B) has a number average molecular weight in terms of polystyrene, as measured by gel permeation chromatography, of 1,000 to 100,000.

4. An optical waveguide comprising a lower clad layer, a core portion, and an upper clad layer, wherein at least each of the lower clad layer and the upper clad layer is a cured product of the radiation-sensitive resin composition for optical waveguides according to Claim 1.

5. The optical waveguide according to Claim 4, wherein each of the lower clad layer, the core portion, and the upper clad layer is a cured product of the radiation-sensitive resin composition according to Claim 1, and the core portion has a refractive index at least 0.1 % higher than respective refractive indexes of the lower clad layer and the upper clad layer.

6. An method for manufacturing an optical waveguide comprising a lower clad layer, a core portion, and an upper clad layer, wherein the method comprises a step for forming the lower clad layer, a step for forming the core portion, and a step for forming the upper clad layer, and wherein at least each of the step for forming the lower clad layer and the step for forming the upper clad layer includes a step in which the radiation-sensitive resin composition according to Claim 1 is irradiated with radiation to be cured.

## Patentansprüche

1. Strahlungsempfindliche Harzzusammensetzung für optische Wellenleiter, die umfasst:
(A) ein Polymer mit einer durch die allgemeine Formel (1) dargestellten Wiederholungseinheit 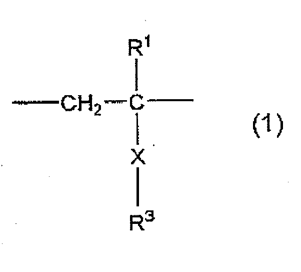 (in der Formel ist R¹ ein Wasserstoffatom oder eine Methylgruppe, R³ ist eine (Meth)Acryloylgruppe, X ist eine zweiwertige organische Gruppe);
(B) eine Urethan(meth)acrylatverbindung, welche ein Reaktionsprodukt einer Polyesterpolyolverbindung, einer Polyisocyanatverbindung und eines (Meth)Acrylats mit einer Hydroxylgruppe ist;
(C) eine Verbindung mit zumindest einer ethylenisch ungesättigten Gruppe und mit einem Siedepunkt bei 0,1 MPa von 130°C oder höher, die sich von den Verbindungen (A) und (B) unterscheidet; und
(D) einen Fotoradikalpolymerisationsinitiator.

2. Strahlungsempfindliche Harzzusammensetzung nach Anspruch 1, wobei die allgemeine Formel (1) eine durch die folgende allgemeine Formel (3) dargestellte Struktur darstellt, 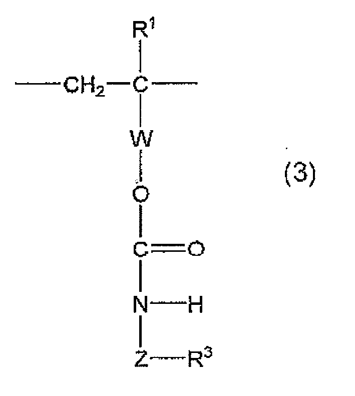 (in der Formel ist R¹ ein Wasserstoffatom oder eine Methylgruppe, R³ ist eine (Meth)Acryloylgruppe, W und Z sind jeweils unabhängig eine Einfachbindung oder eine zweiwertige organische Gruppe).

3. Strahlungsempfindliche Harzzusammensetzung nach Anspruch 1, wobei Bestandteil (B) ein zahlengemitteltes Molekulargewicht bezüglich Polystyrol, wie durch Gelpermeationschromatographie gemessen, von 1.000 bis 100.000 aufweist.

4. Optischer Wellenleiter, der eine untere Mantelschicht, einen Kernabschnitt und eine obere Mantelschicht umfasst, wobei zumindest jede aus der unteren Mantelschicht und der oberen Mantelschicht ein gehärtetes Produkt der strahlungsempfindlichen Harzzusammensetzung für optische Wellenleiter nach Anspruch 1 ist.

5. Optischer Wellenleiter nach Anspruch 4, wobei jede aus der unteren Mantelschicht, des Kernabschnitts und der oberen Mantelschicht ein gehärtetes Produkt der strahlungsempfindlichen Harzzusammensetzung nach Anspruch 1 ist, und der Kernabschnitt einen Brechnungsindex von zumindest 0,1% höher als die entsprechenden Brechungsindizes der untere Mantelschicht und der oberen Mantelschicht aufweist.

6. Verfahren zum Herstellen eines optischen Wellenleiters, der eine untere Mantelschicht, einen Kernabschnitt und eine obere Mantelschicht umfasst, wobei das Verfahren einen Schritt zum Bilden der unteren Mantelschicht, einen Schritt zum Bilden des Kernabschnitts und einen Schritt zum Bilden der oberen Mantelschicht umfasst, wobei zumindest jeder aus dem Schritt zum Bilden der unteren Mantelschicht und dem Schritt zum Bilden der oberen Mantelschicht einen Schritt beinhaltet, bei welchem die strahlungsempfindliche Harzzusammensetzung nach Anspruch 1 mit Strahlung bestrahlt wird, um gehärtet zu werden.

## Revendications

1. Composition de résine sensible aux rayonnements pour guides d'ondes optiques, comprenant :
(A) un polymère ayant une unité répétitive représentée par la formule générale (1) suivante 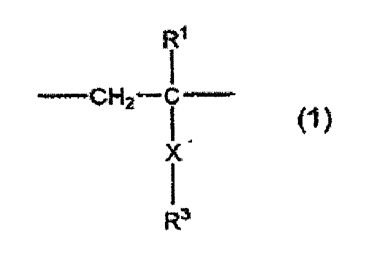 (dans la formule, R¹ est un atome d'hydrogène ou un groupe méthyle, R³ est un groupe (méth)acryloyle, X est un groupe organique bivalent) ;
(B) un composé de (méth)acrylate d'uréthane qui est un produit de réaction d'un composé de polyester polyol, d'un composé de polyisocyanate, et d'un (méth)acrylate ayant un groupe hydroxyle ;
(C) un composé ayant au moins un groupe éthyléniquement insaturé et ayant un point d'ébullition de 130°C ou plus sous 0,1 MPa autre que les composants (A) et (B) ; et
(D) un initiateur de polymérisation photo-radicalaire.

2. Composition de résine sensible aux rayonnements selon la revendication 1, dans laquelle la formule générale (1) représente une structure représentée par la formule générale (3) suivante 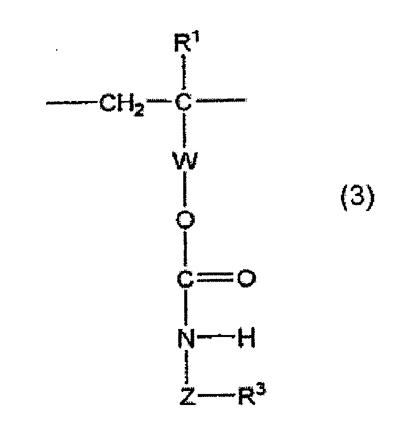 (dans la formule, R¹ est un atome d'hydrogène ou un groupe méthyle, R³ est un groupe (méth)acryloyle, W et Z sont chacun indépendamment une liaison simple ou un groupe organique bivalent).

3. Composition de résine sensible aux rayonnements selon la revendication 1, dans laquelle le composant (B) a un poids moléculaire moyen en nombre en termes de polystyrène, tel que mesuré par chromatographie par perméation de gel, de 1 000 à 100 000.

4. Guide d'ondes optique comprenant une couche de revêtement inférieure, une partie de coeur, et une couche de revêtement supérieure, dans lequel au moins chacune de la couche de revêtement inférieure et de la couche de revêtement supérieure est un produit durci de la composition de résine sensible aux rayonnements pour guides d'ondes optiques selon la revendication 1.

5. Guide d'ondes optique selon la revendication 4 dans lequel chacune de la couche de revêtement inférieure, de la partie de coeur, et de la couche de revêtement supérieure est un produit durci de la composition de résine sensible aux rayonnements selon la revendication 1, et la partie de coeur a un indice de réfraction au moins 0,1% supérieur aux indices de réfraction respectifs de la couche de revêtement inférieure et de la couche de revêtement supérieure.

6. Procédé de fabrication d'un guide d'ondes optique comprenant une couche de revêtement inférieure, une partie de coeur, et une couche de revêtement supérieure, dans lequel le procédé comprend une étape de formation de la couche de revêtement inférieure, une étape de formation de la partie de coeur, et une étape de formation de la couche de revêtement supérieure, et dans lequel au moins chacune de l'étape de formation de la couche de revêtement inférieure et de l'étape de formation de la couche de revêtement supérieure inclut une étape dans laquelle la composition de résine sensible aux rayonnements selon la revendication 1 est irradiée avec un rayonnement pour être durcie.
